# EUROPÄISCHE PATENTSCHRIFT

(11) **EP 1 062 850 B1**
(45) Veröffentlichungstag und Bekanntmachung des Hinweises auf die Patenterteilung: **30.05.2007**
(21) Anmeldenummer: 99964434.7
(22) Anmeldetag: 10.12.1999
(51) Int. Cl.: H05K 3/00

(54) **VERFAHREN ZUR HERSTELLUNG VON LEITERBAHNSTRUKTUREN**
METHOD FOR PRODUCING PRINTED CONDUCTOR STRUCTURES
PROCEDE DE PRODUCTION DE STRUCTURES DE TRACES CONDUCTRICES

(30) Priorität: 10.12.1998 DE 19856888
(43) Veröffentlichungstag der Anmeldung: 27.12.2000
(73) Patentinhaber: LPKF Laser & Electronics Aktiengesellschaft, 30827 Garbsen (DE)
(72) Erfinder: Naundorf, Gerhard, Prof. Dr., 32657 Lemgo (DE); Wissbrock, Horst, Prof. Dr., 32760 Detmold (DE)
(74) Vertreter: Scheffler, Jörg
(86) Internationale Anmeldenummer: PCT/DE1999/003965
(87) Internationale Veröffentlichungsnummer: WO 2000/035259

(56) Entgegenhaltungen:
- EP-A- 0 225 422
- WO-A-99/05895
- DE-A- 19 723 734
- US-A- 5 032 488
- US-A- 5 405 656

## Beschreibung

Die Erfindung betrifft ein Verfahren zur Herstellung von feinen metallischen Leiterbahnstrukturen auf einem elektrisch nichtleitenden Trägermaterial, bei dem ein elektrisch nicht leitender Schwermetallkomplex auf das Trägermaterial aufgebracht oder in das Trägermaterial eingebracht wird, das Trägermaterial im Bereich der zu erzeugenden Leiterbahnstrukturen selektiv einer UV-Laserstrahlung ausgesetzt wird, wobei Schwermetallkeime freigesetzt werden, und dieser Bereich chemisch reduktiv metallisiert wird.

Durch den Sonderdruck "LAD - Ein neuartiges lasergestütztes Beschichtungsverfahren für Feinstleitermetallisierungen" aus Heft Nummer 10, Band 81 (1990), der Fachzeitschrift "Galvanotechnik", ist es bekannt geworden, zur Herstellung von Feinstleiterstrukturen von deutlich unter 100 µm auf einem nichtleitenden Trägermaterial vollflächig Pd-Acetat aus einer Lösung als dünnen Film aufzubringen. Durch eine nachfolgende Laserbelichtung mittels eines Excimerlasers mit einer Wellenlänge von 248 nm sollen dann im Bereich der zu erzeugenden Leiterbahnstrukturen Metallatome als Keime für eine nachfolgende stromlose Metallisierung freigesetzt werden. Vor der Metallisierung ist es jedoch erforderlich, einen Spülprozeß zur Entfernung der unzersetzten Bereiche des auf das Trägermaterial aufgebrachten metallhaltigen Filmes durchzuführen. Der Qualität dieses Spülprozesses kommt dabei eine entscheidende Rolle für die Vermeidung von Wildwuchsproblemen bei der nachfolgenden stromlosen Metallisierung zu. Im übrigen hat es sich gezeigt, daß mittels des beschriebenen Verfahrens keine ausreichende Haftfestigkeit der abgeschiedenen metallischen Leiterbahnen erzielbar ist.

In der DE 42 10 400 C1 ist ein Verfahren zur direkten Abscheidung von Kupfer, aus einem auf ein Substrat aufgebrachten Film aus einem Gemisch von Schwermetallsalzen durch lokales Erhitzen mittels eines Lasers beschrieben. Dieses Verfahren liegt im Bereich der thermisch aktivierten Chemie mit dem Nachteil, daß die Feinheit der erzielbaren Leiterbahnstrukturen begrenzt ist. Zudem handelt es sich bei dem aufgebrachten Film um einen elektrisch leitenden Film, so daß vor der Metallisierung ein aufwendiger und problematischer Spülprozeß erforderlich ist. Der Einsatz eines nicht leitenden Schwermetallkomplexes und ein kaltes Aufbrechen des Schwermetallkomplexes mittels einer UV-Laserstrahlung zur Abspaltung der Schwermetallkeime ist hier weder offenbart noch nahegelegt.

Durch die US 45 74 095 ist ein Verfahren bekannt geworden, bei dem ein Substrat in einer Vakuumkammer dem Dampf einer Palladium-Komplexverbindüng ausgesetzt wird und dann durch ein Fenster strukturierend mit einem 249 nm-Excimerlaser bestrahlt wird. Dieses Verfahren ist, da die Palladium-Abscheidung aus einer dampfförmigen Phase in einer Vakuumkammer erfolgt, so aufwendig, daß ein Einsatz im Bereich konventioneller Leiterplatten und Schaltungsträger nicht wirtschaftlich ist.

Die US-A-5 032 488 beschreibt auch bereits ein Verfahren zur Herstellung von feinen metallischen Leiterbahnstrukturen auf einem elektrisch nichtleitenden Trägermaterial, bei dem ein elektrisch nicht leitender Schwermetallkomplex auf das Trägermaterial aufgebracht oder in das Trägermaterial eingebracht wird. Das Trägermaterial wird im Bereich der zu erzeugenden Leiterbahnstrukturen selektiv einer UV-Laserstrahlung ausgesetzt, wobei Schwermetallkeime freigesetzt werden, und dieser Bereich chemisch reduktiv metallisiert wird.

Aufgabe der Erfindung ist es, ein vereinfachtes und sicheres Verfahren zur Herstellung der Leiterbahnstrukturen zu schaffen, das eine Feinststrukturierung der Leiterbahnen bis hinab zu Leiterbahnbreiten und -abständen von 10 µm sicher gewährleistet.

Diese Aufgabe wird durch ein Verfahren mit den Merkmalen des Anspruchs 1 gelöst. Dabei wird der Schwermetallkomplex mit organischen Komplexbildnern mit chemischen Strukturen der molekularen Kombinationen von sterisch gehinderten Phenolen und metallkomplexierenden Gruppen wie (XII), (XIII), (XIV) und (XV) 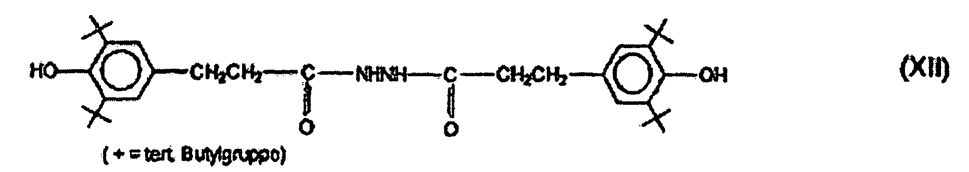 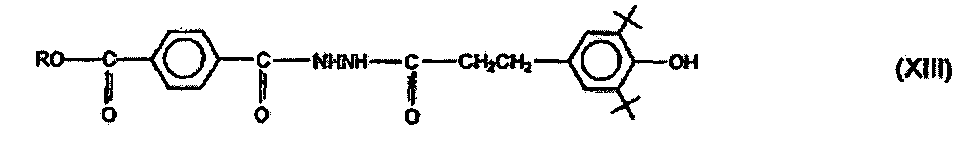 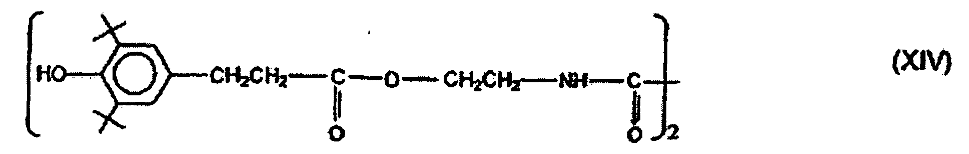 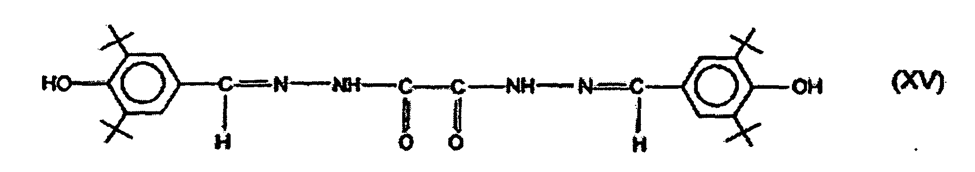 gebildet.

Die genannten Komplexbildner weisen die vorteilhaften Eigenschaften auf, daß sie in Polymerphasen ausreichend löslich bzw. leicht dispergierbar und zudem gut verträglich sind. Aufgrund der guten Verträglichkeit können schädliche Ausblüheffekte vermieden werden.

Außerdem sind die genannten Komplexbildner hoch extraktionsbeständig und in alkalischen und sauren chemischen und galvanischen Bädern beständig. Auch sind diese Komplexbildner in vorteilhafter Weise nicht flüchtig und nicht akut toxisch sowie nicht haut- und schleimhautreizend.

Die durch Umsetzung der genannten organischen Komplexbildner mit Schwermetallsalzen gebildeten Schwermetallkomplexe zeichnen sich dadurch aus, daß sie temperaturbeständig sind und daß ihre Zersetzungstemperatur oberhalb der Spritzgießtemperatur thermoplastischer Kunststoffe bzw. der Aushärtetemperatur der Beschichtung liegt. Auch die Temperatureinwirkung während der Lötvorgänge kann keine Zersetzung der erfindungsgemäß eingesetzten Schwermetallkomplexe auslösen. Die Schwermetallkomplexe bleiben folglich auch im Umfeld der Leiterbahnen nichtleitend.

Indem als schwermetallhaltige Komponente nichtleitende organische Schwermetallkomplexe verwendet werden, die durch Umsetzung von Schwermetallsalzen mit organischen Komplexbildnern gebildet sind und mittels der UV-Strahlung durch ein Aufbrechen der Schwermetallkomplexe im Bereich der Leiterbahnen die Schwermetallkeime abgespalten werden, ist erreicht worden, daß nach der Einwirkung der UV-Strahlung direkt anschließend die chemisch reduktive Metallisierung erfolgen kann. Im Bereich der zu erzeugenden Leiterbahnstrukturen erfolgt durch die Einwirkung der UV-Strahlung ein Aufbrechen des Schwermetallkomplexes, wodurch für die partielle reduktive Metallisierung hochreaktive Schwermetallkeime abgespalten werden. Die Metallisierung erfolgt ohne jeden Wildwuchs unter Ausbildung sehr scharfer Konturen. Da die gebildeten Schwermetallkeime hochreaktiv sind, wird die erwünschte exakte Metallisierung in der erforderlichen Schichtdicke zusätzlich begünstigt. Da das Trägermaterial eine mikroporöse Oberfläche aufweist, wird außerdem eine hervorragende Haftfestigkeit der abgeschiedenen metallischen Leiterbahnen erzielt.

Die Schwermetallkomplexe können in einem Lösungsmittel, z. B. Dimethylformamid, gelöst auf ein poröses Trägermaterial bzw. auf ein Trägermaterial mit poröser Oberfläche aufgetragen werden. Hierbei kann es sich z. B. um eine flexible Polyimid-Membranfolie mit mikroporöser Oberfläche oder aber auch um Papier handeln. Der Schwermetallkomplex kann hier in die Poren des Materials eindringen. Bei der nachfolgenden Metallisierung ist für die Haftung des Leiterzuges die Porenstruktur vorteilhaft, in die bei der Metallisierung das beispielsweise verwendete Kupfer hineinwächst und sich dann dort wurzelförmig verklammert. Die erzielbaren, sehr feinen Strukturen werden dadurch begünstigt, daß eine Haftvermittlerschicht nicht erforderlich ist und von daher keine untere Grenze möglicher Leiterbahnbreiten vorgegeben ist. Zusätzlich ermöglicht die hier eingesetzte UV-Strahlung aufgrund ihrer Kurzwelligkeit feinste scharf ausgebildete Strukturen mit Metallisierungskeimen.

Alternativ ist es vorgesehen, daß das Trägermaterial von mikroporösen oder mikrorauhen Trägerpartikeln gebildet ist, die Trägerpartikel in das Trägermaterial eingemischt und/oder auf das Trägermaterial aufgebracht und angebunden werden, auf das Trägermaterial die elektromagnetische UV-Strahlung im Bereich der zu erzeugenden Leiterbahnstrukturen selektiv aufgebracht wird, derart, daß Trägerpartikel durch Abtrag freigelegt und dann durch ein Aufbrechen des angebundenen Schwermetallkomplexes die Schwermetallkeime freigesetzt werden und dieser Bereich zur Ausbildung der Leiterbahnstrukturen anschließend chemisch-reduktiv metallisiert wird.

Gemäß einer bevorzugten Ausführungsform der Erfindung werden als Schwermetallsalze Palladiumsalze eingesetzt. Alternativ können die Palladiumsalze auch in Verbindung mit den Salzen anderer Schwermetalle eingesetzt werden. Vorteilhaft kann es auch sein, wenn als Schwermetallsalz ein Palladiumdiacetat eingesetzt wird. Vorzugsweise werden Pd-Komplexe bzw. Pd-haltige Schwermetallkomplexe eingesetzt. Wie sich gezeigt hat, sind derartige Schwermetallkomplexe besonders gut zur Feinststrukturierung gemäß dem erfindungsgemäßen Verfahren geeignet. Insbesondere ist für die Einleitung der strukturierenden Spaltungsreaktion eine UV-Strahlung einer wesentlich geringeren Energiedichte ausreichend, als für das Abtragen bei bekannten Systemen. Zusätzlich wird erreicht, daß im Zusammenhang mit der Strukturierung pro Laserimpuls eines Excimerlasers wesentlich größere Flächen belichtet werden können, als bei bekannten Ablationstechniken.

Im Rahmen der Erfindung ist es außerdem vorgesehen, daß zur Abspaltung der Schwermetallkeime aus dem Schwermetallkomplex vorzugsweise ein Kr F-Excimerlaser mit einer Wellenlänge von 248,5 nm oder aber ein frequenzverdreifachter Nd:YAG-Laser mit einer Wellenlänge von 355 nm eingesetzt wird. Es ist so möglich, die Abspaltung ohne Aufheizung des Komplexes durchzuführen. Hierdurch wird ein Aufschmelzen von Materialien im Einwirkungsbereich vermieden. Die Folge ist eine sehr hohe Begrenzungsschärfe der Bereiche mit abgespalteten Schwermetallkeimen und sich daraus ergebend eine sehr hohe, äußerst vorteilhafte Kantenschärfe der metallisierten Strukturen, was insbesondere bei Feinstleitern von großer Bedeutung ist.

Das erfindungsgemäße Verfahren kann sowohl mit flächig aufgebrachter Laserstrahlung und Maskentechnik in einer rationellen Massenfertigung eingesetzt werden, als auch maskenlos über eine beispielsweise NC-gesteuerte Führung eines punktförmig fokussierten Laserstrahls Anwendung finden.

Das folgende Ausführungsbeispiel stellt keine Ausführungsform der Erfindung dar, ist aber nützlich zu deren Verständnis!

Es werden 2,24 Masseteile Palladiumdiacetat in 100 Masseteilen Dimethylformamid gelöst. Außerdem werden 2,94 Masseteile des organischen Komplexbildners der Formel 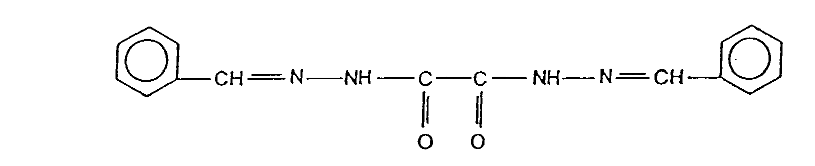 in 800 Masseteile Dimethylformamid eingebracht und durch Erwärmen gelöst. Beide Lösungen werden dann gemischt und zur Reaktion gebracht. Unmittelbar danach, bevor die Lösung abkühlt und der entstandene Palladiumkomplex ausfällt, wird eine mikroporöse Polyimid-Folie in der Lösung getränkt. Nach 10 Stunden Trocknung bei Raumtemperatur wird das so erhaltene Basismaterial mit einem Kr F-Excimerlaser, d. h. einem Excimerlaser mit einer Wellenlänge von 248,5 nm, über eine Maske bestrahlt. In den bestrahlten Bereichen wird dabei feinstverteiltes metallisches Palladium aus dem Komplex abgespalten. In einem handelsüblichen reduktiven, außenstromlosen Kupferbad scheidet sich selektiv in den bestrahlten Bereichen haftfest verankertes Kupfer ab. Die Leiterzüge sind ausgebildet; es liegt eine einsatzfähige flexible Schaltung vor.

Wie sich gezeigt hat, ist das erfindungsgemäße Verfahren auch zum Aufbringen von Leiterbahnstrukturen auf Schaltungsträger möglich, die aus anderen nichtleitenden Materialien mit mikroporöser Oberfläche, wie z. B. aus keramischen Basismaterialien oder auch aus Glas, bestehen.

Es liegt im Rahmen der Erfindung, daß Schwermetallkomplexe auch in das Trägermaterial eingebracht werden können, z. B. in einen thermoplastischen Kunststoff. Durch die Einwirkung der UV-Laserstrahlung auf die Oberfläche des Spritzgußteiles im Bereich der aufzubringenden Leiterbahnen erfolgt dann eine Ablation des Trägermaterials unter Aufbrechen der freigelegten Schwermetallkomplexe, wobei Schwermetallkeime abgespalten werden, die zur Ausbildung der Leiterbahnen eine stromlose Metallisierung ermöglichen.

## Patentansprüche

1. Verfahren zur Herstellung von feinen metallischen Leiterbahnstrukturen auf einem elektrisch nichtleitenden Trägermaterial, bei dem ein elektrisch nicht leitender Schwermetallkomplex auf das Trägermaterial aufgebracht oder in das Trägermaterial eingebracht wird, das Trägermaterial im Bereich der zu erzeugenden Leiterbahnstrukturen selektiv einer UV-Laserstrahlung ausgesetzt wird, wobei Schwermetallkeime freigesetzt werden, und dieser Bereich chemisch reduktiv metallisiert wird, **dadurch gekennzeichnet, daß** der Schwermetallkomplex mit organischen Komplexbildnern mit chemischen Strukturen der molekularen Kombinationen von sterisch gehinderten Phenolen und metallkomplexierenden Gruppen gebildet wird.

## Claims

1. Method for producing fine metallic strip conductor structures on an electrically non-conductive substrate, in which an electrically non-conductive heavy metal complex is applied to the substrate or introduced into the substrate and in which the substrate is selectively subjected to UV laser radiation in the region of the conductor structures to be produced, heavy metal nuclei being released and this region being coated with metal by chemical reduction, **characterised in that** the heavy metal complex is formed by organic complexing agents having chemical structures of molecular combinations of sterically hindered phenols and metal complexing groups.

## Revendications

1. Procédé permettant de fabriquer des structures de tracé conducteur métalliques fines sur un matériau support non-électroconducteur, dans lequel un complexe de métaux lourds non-électroconducteur est appliqué sur le matériau support ou intégré dans le matériau support, le matériau support est soumis, dans la zone des structures de tracé conducteur à produire, sélectivement à un rayonnement laser UV, moyennant quoi des germes de métaux lourds sont libérés, et cette zone est métallisée par réduction chimique, **caractérisé en ce que** le complexe de métaux lourds est formé avec des générateurs de complexes organiques comportant les structures chimiques des combinaisons moléculaires de phénols entravés au niveau stérique et de groupes complexant les métaux.
